Europäisches Patentamt

European Patent Office

Office européen des brevets

(11) Veröffentlichungsnummer: **0 283 894**

**A1**

## EUROPÄISCHE PATENTANMELDUNG

(21) Anmeldenummer: **88104028.1**

(22) Anmeldetag: **14.03.88**

(51) Int. Cl.⁴: **H05K 13/02**

(30) Priorität: **25.03.87 DE 8704390 U**

(43) Veröffentlichungstag der Anmeldung:
**28.09.88 Patentblatt 88/39**

(84) Benannte Vertragsstaaten:
**AT BE CH DE FR GB IT LI NL**

(71) Anmelder: **Siemens Aktiengesellschaft Berlin und München**
**Wittelsbacherplatz 2**
**D-8000 München 2(DE)**

(72) Erfinder: **Schulze-Kahleyss, Rainer**
**Dompfaffstrasse 136**
**D-8520 Erlangen(DE)**

(54) **Vorrichtung zum Versorgen eines Bestückautomaten für Leiterplatten mit integrierten Bauelementen.**

(57) Üblicherweise werden die IC's zur Bestückung in stangenartigen Magazinen gestapelt angeliefert und über eine lateral verschiebbare Trägereinrichtung dem Bestückautomaten zugeführt. Gemäß der Erfindung ist ein Kupplungsteil (10) vorgesehen, mit dem in der Trägereinrichtung (1) gehalterten Stangenmagazine (9) mit einem weiteren Satz von Stangenmagazinen (19) verbindbar sind. Dadurch wird das Bestückvolumen um 100 % vergrößert.

FIG 2

EP 0 283 894 A1

## Vorrichtung zum Versorgen eines Bestückautomaten für Leiterplatten mit integrierten Bauelementen

Die Erfindung bezieht sich auf eine Vorrichtung zum Versorgen eines Bestückautomaten für Leiterplatten mit integrierten Bauelementen (IC's), die in stangenartigen Magazinen gestapelt angeliefert werden und über eine lateral verschiebbare Trägereinrichtung dem Bestückautomaten zuführbar sind.

Vom Stand der Technik ist es bekannt, Leiterplatten automatisch zu bestücken. Insbesondere als sogenannte DIP-Bauelemente (dual inline package) ausgebildete IC's werden dabei in stangenartigen Magazinen gestapelt angeliefert, in eine Trägereinrichtung gesteckt, die relativ zur Aufnahmeeinheit des Bestückautomaten verschiebbar ist, so daß nacheinander mehrere Magazine abgearbeitet werden können. Dabei wird das Bestückvolumen durch die Aufnahmefähigkeit des Stangenmagazins und durch die Ausbildung der lateral verschiebbaren Trägereinrichtung zur Aufnahme einer Reihe von Stangenmagazinen begrenzt. Die Stangenmagazine haben aus lagerungstechnischen Gründen eine Länge von ca. 50 cm.

In der Praxis wird bei Bestückautomaten insbesondere durch vorgeschaltete Transportsysteme zum Be-und Entladen der Leiterplatten die Zugänglichkeit zum eigentlichen Bestückautomaten erschwert. Bisher muß daher speziell bei Einsatz von Robotern der Bestückautomat zum Ersatz von Stangenmagazinen stillgesetzt werden.

Aufgabe der Erfindung ist es daher, bei einer Vorrichtung der eingangs genannten Art Maßnahmen zur Erhöhung des Bestückvolumens anzugeben.

Die Aufgabe ist erfindungsgemäß dadurch gelöst, daß ein Kupplungsteil vorgesehen ist, mit dem die in der Trägereinrichtung gehaltenen Stangenmagazine mit einem weiteren Satz von Stangenmagazinen verbindbar sind. Vorteilhafterweise ist dabei das Kupplungsteil ein Formteil, das eine der Anzahl von Stangenmagazinen angepaßte Anzahl von Durchführungen aufweist.

In ein derartiges Kupplungsteil können die Stangenmagazine von beiden Seiten derart eingeschoben werden, daß sie bündig aneinander anschließen. Die gestapelten Bauelemente können ohne Behinderung derart nachrutschen als ob nur ein einziges Magazin vorhanden wäre.

Durch die Erfindung läßt sich in vorteilhafter Weise die Erhöhung des Bestückvolumens um 100 % erreichen. Beispielsweise bei Bestückautomaten mit Roboter-Transportsystemen ist durch die Erfindung ein Stillsetzen der Anlage nicht mehr so häufig erforderlich, so daß sich eine beachtliche Kosteneinsparung ergibt. Darüber hinaus führt das größere Gewicht der im Magazin gestapelten IC's zu weniger Störungen bei Einlauf in die Maschine.

Im Rahmen der Erfindung können als Kupplungsteil bereits vorhandene Bauteile, wie das Trägerteil, verwendet werden, die entsprechend modifiziert sind. Insbesondere ist dafür die Basis des Trägerteils entfernt. Jeder Durchführung im Kupplungsteil ist dabei ein zungenartiges Führungsteil zum Eingriff in das stangenartige Magazin und eine Gegendruckfeder zugeordnet. Diese Einheiten sind auch bei den Trägerteilen vorhanden und also an sich vorbekannt. Alle Teile können zweckmäßigerweise aus Kunststoff bestehen und sind damit preisgünstig herstellbar.

Weitere Einzelheiten und Vorteile der Erfindung ergeben sich aus der nachfolgenden Figurenbeschreibung eines Ausführungsbeispiels anhand der Zeichnung. Es zeigen

FIG 1 in Seitenansicht die Gesamtvorrichtung einschließlich Trägerteil und Kupplungsteil,

FIG 2 das Kupplungsteil und

FIG 3 einen Schnitt durch FIG 2 mit zugehöriger Vergrößerung einer Einzeldurchführung.

In den Figuren sind identische Teile mit gleichen Bezugzeichen versehen. Die Figuren werden nachfolgend teilweise zusammen beschrieben.

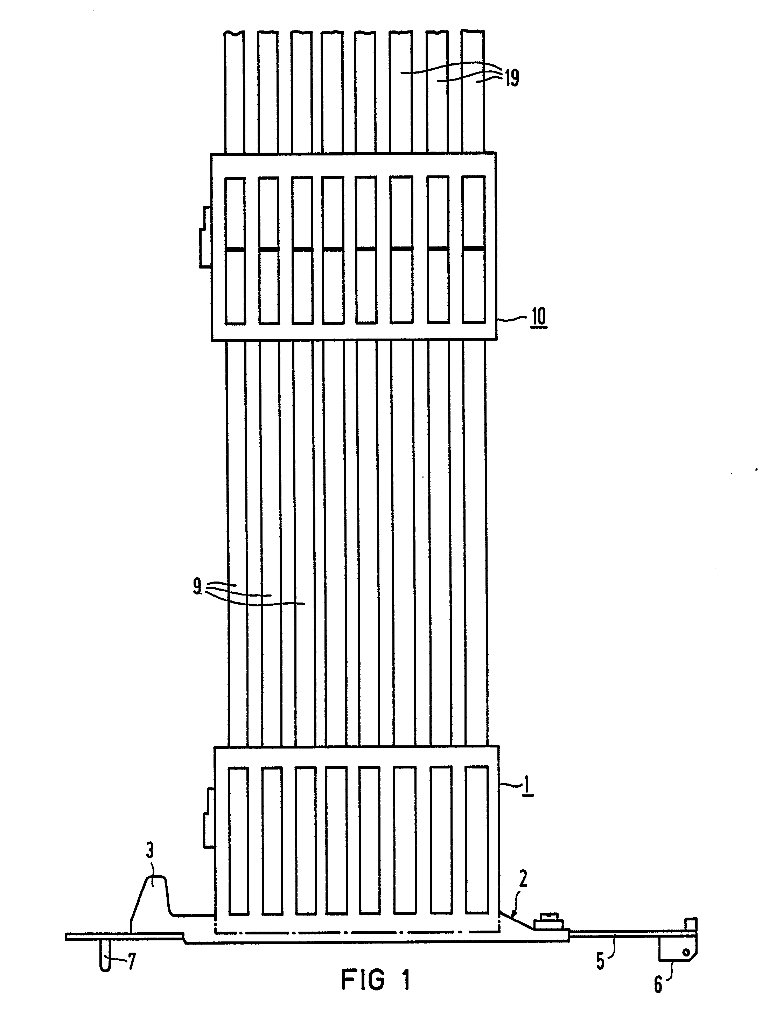

In FIG 1 ist mit 1 ein Trägerteil (sog. carrier) bezeichnet, das im wesentlichen aus einem Basisteil 2 mit Greifnocken 3 besteht und mit seiner unteren Standfläche gegenüber einer Schiene 5 (sog. blade) verschiebbar ist. Die Schiene 5 weist eine Halterung 6 und einen Eingreifriegel 7 auf, mit denen die gesamte Einrichtung auf dem (nicht dargestellten) Bestückautomaten befestigbar ist.

In das Trägerteil sind acht gleiche stangenartige Magazine 9 (sog. sticks) eingeschoben. Diese Magazine bestehen aus Kunststoff, in denen die IC's aufeinander gestapelt vom Hersteller geliefert werden. Von der Bedienperson werden die Stangenmagazine 9 in das Trägerteil 1 eingesteckt und bis zum Anschlag vorgeschoben. Durch Lateralverschiebung des Trägerteils 1 gegenüber dem Bestückautomaten kann der in den Magazinen 9 angelieferte Vorrat an Bauelementen nacheinander abgearbeitet werden. Sind die Magazine 9 leer, werden sie mit dem Trägerteil 1 entnommen und durch neue, mit Bauelementen gefüllte Magazine 9 ersetzt.

In FIG 1 ist auf das freie Ende der Stangenmagazine 9 ein Kupplungsteil 10 aufgesetzt und bis etwa auf die Hälfte seiner Höhe aufgeschoben. Von der freien Seite ist ein weiterer Satz von Stangenmagazinen 19 eingeschoben, wobei sich jeweils ein einzelnes Magazin 9 und ein weiteres Magazin 19 bündig aneinander anschließen. Dabei kann die Höhe der Anschlußstelle in Abhängigkeit von der exakten Länge eines einzelnen unteren Stangenmagazins 9 über die Breite des Kupplungsteiles 10 variieren.

Durch das Kupplungsteil 10 läßt sich also im vorliegenden Fall das Bestückvolumen um 100 % erhöhen. Damit wird ein erheblicher Rationalisierungseffekt erreicht.

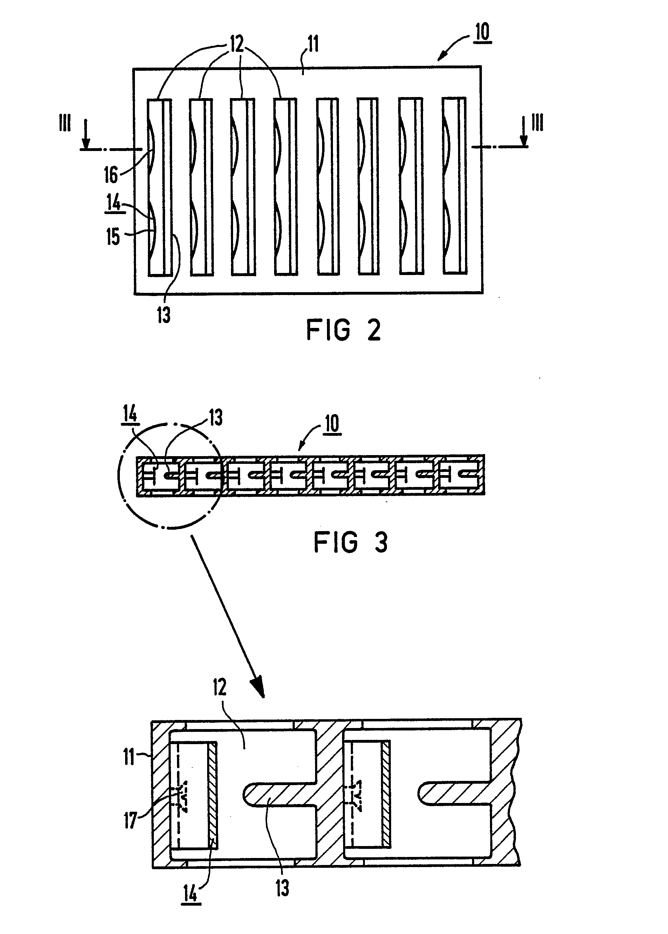

Das Kupplungsteil 10 kann im wesentlichen dem oberen Teil des Trägerteils 1 entsprechen. Gemäß FIG 2 und 3 besteht es aus einem kastenartigen Rahmen 11 in symmetrischem Aufbau, in dem acht parallele Durchführungen 12 eingebracht sind. Jede Durchführung 12 weist auf gegenüberliegenden Seiten ein zungenartiges Führungsteil 13 und eine Andruckfeder 14 auf. Form und Wirkung der Führungszunge 13 und zugehörigen Gegendruckfeder 14 sind aus FIG 3 und insbesondere der Ausschnittszeichnung zu FIG 3 entnehmbar.

Durch die Führung 13 und die zugehörige Gegendruckfeder 14 ergibt sich für die stangenartigen Magazine 9 bzw. 19, deren Querschnitt zum Stapeln der IC's etwa U-Form haben, eine exakte Führung. Durch die Form der Feder 14 mit zwei Federbögen 15 und 16 können insbesondere zwei aufeinander stoßende Magazine 9 und 19 so geführt werden, daß sie ohne Stoßkante aneinander anschließen und ein problemloses Durchrutschen der IC's sicherstellen. Dadurch, daß nunmehr mehr IC's gestapelt sind, ergibt sich ein größeres Gewicht und eine Verringerung von Störungen bei der Versorgung von Bestückautomaten.

Alle Einzelteile des Kupplungsteiles 10, insbesondere das Kastenteil 11, das Führungsteil 13 und die Feder 14 können aus geeignetem Kunststoff bestehen. Die zungenartige Führung 13 kann mit dem Rahmenteil 11 an den Durchführungen eine Einheit bilden. Die Lagerung der Feder 14 kann durch einen Kunststoffnippel 17 gebildet sein.

## Ansprüche

1. Vorrichtung zum Versorgen eines Bestückautomaten für Leiterplatten mit integrierten Bauelementen (IC's), die in stangenartigen Magazinen gestapelt angeliefert werden und über eine lateral verschiebbare Trägereinrichtung dem Bestückautomaten zuführbar sind , **dadurch gekennzeichnet,** daß ein Kupplungsteil (10) vorgesehen ist, mit dem die in der Trägereinrichtung (1) gehalterten Stangenmagazine (9) mit einem weiteren Satz von Stangenmagazinen (19) verbindbar sind.

2. Vorrichtung nach Anspruch 1 , **dadurch gekennzeichnet,** daß das Kupplungsteil (10) ein Formteil ist, das eine der Anzahl von Stangenmagazinen (9, 19) angepaßte Anzahl von Durchführungen (11) aufweist.

3. Vorrichtung nach Anspruch 2 , **dadurch gekennzeichnet,** daß jede Durchführung (11) im Kupplungsteil (10) ein zungenartiges Führungsteil (13) zum Eingriff in das stangenartige Magazin (9, 19) und eine Gegendruckfeder (14) aufweist.

4. Vorrichtung nach Anspruch 3 , **dadurch gekennzeichnet,** daß das Führungsteil (13) und die Gegendruckfeder (14, 15, 16) an wenigstens zwei Stellen im Kupplungsteil (1) auf die sich anschließenden Magazine (9, 19) einwirken, so daß ein bündiger Anschluß zweier sich entsprechender Magazine (9, 19) gegeben ist.

5. Vorrichtung nach einem der vorhergehenden Ansprüche , **dadurch gekennzeichnet,** daß das Kupplungsteil (1) einschließlich der Führungsteile (13) und der zugehörigen Gegendruckfedern (14, 15, 16) aus Kunststoff bestehen.

19

10

9

1

3

7

2

5

6

FIG 1

**FIG 2**

**FIG 3**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | EP-A-0 134 911 (LEMMER) <br> * Seite 7, Zeilen 11-27; Seite 9, Zeile 25 - Seite 10, Zeile 7; Ansprüche 25-27; Figuren 1-6 * <br> ----- | 1-3,5 | H 05 K 13/02 |
| | | | **RECHERCHIERTE SACHGEBIETE (Int. Cl.4)** |
| | | | H 05 K 13/00 |

Der vorliegende Recherchenbericht wurde für alle Patentansprüche erstellt

| Recherchenort | Abschlußdatum der Recherche | Prüfer |
|---|---|---|
| DEN HAAG | 09-06-1988 | RIEUTORT A.S. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
........................................................................
& : Mitglied der gleichen Patentfamilie, übereinstimmendes
    Dokument

EPO FORM 1503 03.82 (P0403)